# EUROPEAN PATENT APPLICATION

(11) **EP 4 541 779 A1**
(43) Date of publication of application: **23.04.2025**
(21) Application number: 24192842.3
(22) Date of filing: 05.08.2024
(51) Int. Cl.: C03C 17/36, C03C 17/42, C08J 7/044

(54) **LOW-EMISSIVITY FILM FOR BUILDING AND VEHICLE HAVING EXCELLENT VISIBILITY AND THERMAL INSULATION PERFORMANCE**

(30) Priority: 17.10.2023 KR 20230138643
(71) Applicant: M-Glass Inc., Jeju-si, Jeju-do 63088 (KR)
(72) Inventor: MUN, Jung Hwan, 63051 Jeju-si, Jeju-do (KR); KIM, Hyung Taek, 04331 Seoul (KR)
(74) Representative: BCKIP Part mbB

(57) **Abstract**

The present invention relates to a low-emissivity film for buildings and vehicles that is capable of having excellent visibility and thermal insulation performance. The low-emissivity film for buildings and vehicles comprises: a transparent substrate layer; and an infrared cut-off layer formed on top of the transparent substrate layer by means of sputtering and having a metal layer comprising any one or more metals selected from the group consisting of nickel, chrome, and silver, wherein the low-emissivity film has thermal transmittance of 4.6 W/m²K or less.

## Description

### [Technical Field]

The present invention relates to a low-emissivity film for buildings and vehicles that is capable of having excellent visibility and thermal insulation performance.

### [Background Art]

Sunlight is largely divided into ultraviolet light (with wavelengths between 100 and 380 nm), visible light (with wavelengths between 380 and 780 nm), and infrared light (with wavelengths between 780 and 60,000 nm), and the infrared light is subdivided into near infrared light and far infrared light. Sunlight is composed of about 6% ultraviolet light, about 46% visible light, and about 48% infrared light, and if skin is exposed to the ultraviolet light for long hours, the ultraviolet light may cause skin aging, cancer, etc. Further, the infrared light raises indoor temperature, thereby causing a cooling cost in summer to increase.

A cooling and heating cost is one of important costs in the maintenance of a building. Therefore, heat loss in a building has direct influence on the cooling and heating cost of the building, so that the heat loss is necessarily considered upon the construction of the building.

In the case of the heat loss in a building in winter, the heat loss occurring via external walls is 39%, the heat loss occurring via glass windows is 32%, the heat loss occurring via floors is 9%, and the heat loss occurring via roofs is 19%. Among them, the heat loss occurring via the external walls, roofs, and floors may be prevented as the external walls, roofs, and floors are built together with insulating materials upon the construction of the building.

However, the heat loss occurring via the glass windows cannot be prevented because it is hard to construct the glass window with insulating materials according to the characteristics of the glass windows. Further, balcony expansion apartments have recently increased, and such an expanding apartment has a large quantity of heat loss via glass windows.

To solve such problems, an adhesive thermal insulation sheet for a glass window is disclosed in Korean Patent Application Laid-open No. 2013-0064419. The conventional adhesive thermal insulation sheet for a glass window as disclosed in Korean Patent Application Laid-open No. 2013-0064419 prevents inside air from coming direct contact with outside air using air caps, thereby suppressing indoor temperature from being lowered and saving a heating cost.

However, the conventional adhesive thermal insulation sheet for a glass window is opaque due to the air caps, thereby lowering the visibility of the glass window. As a result, the glass window must be open to check the outside, which causes indoor temperature to be lowered. Further, the air caps provide opaque curved structures due to air bubbles, so that the light received from sunlight is refracted or reflected onto the air caps and thus hard to enter inside, thereby undesirably decreasing an amount of sunshine received from sunlight.

A mean temperature rises due to global warming, and ozone is destructed due to environmental pollution. Due to such climate changes, bad influences of ultraviolet light, infrared light, or solar radiation energy gradually get serious.

Recently, as demands for products capable of building pleasant environments and making a body healthy have increased, technologies for such functional products have been increasingly studied and developed.

### (Prior Art Literature)

### (Patent literature)

Patent literature 1: Korean Patent Application Laid-open No.10-2017-0062091

### [Disclosure]

### [Technical Problem]

Accordingly, the present invention has been made in view of the above-mentioned problems occurring in the related art, and it is an object of the present invention to provide a low-emissivity film for buildings and vehicles that is capable of allowing an infrared cut-off layer to be formed of multi-layered thin metal films, thereby improving optical properties such as visible light transmittance and the like and ensuring excellent thermal insulation performance.

### [Technical Solution]

To accomplish the above-mentioned object, according to the present invention, there is provided a low-emissivity film for buildings and vehicles, including: a transparent substrate layer; and an infrared cut-off layer formed on top of the transparent substrate layer by means of sputtering and having a metal layer comprising any one or more metals selected from the group consisting of nickel, chrome, and silver, wherein the low-emissivity film has thermal transmittance of 5.0 W/m²K or less.

According to the present invention, further, the infrared cut-off layer may be composed of two or more thin films formed by repeating the metal layer, and each thin film may have a thickness between 30 and 100 nm.

According to the present invention, further, the low-emissivity film may further include an ultraviolet cut-off layer formed on the transparent substrate layer.

According to the present invention, further, the low-emissivity film may have a thickness of 3 mil or more.

According to the present invention, further, the low-emissivity film may have thermal transmittance of 4.6 W/m²K or less.

According to the present invention, further, the low-emissivity film may have thermal transmittance of 4.2 W/m²K or less.

According to the present invention, further, the low-emissivity film may have a total solar energy cut-off rate of 60% or more.

According to the present invention, further, the low-emissivity film may have a total solar energy cut-off rate of 75% or more.

According to the present invention, further, the low-emissivity film may have a heat cut-off rate of 99% or more.

### [Advantageous Effects]

According to the present invention, the low-emissivity film for buildings and vehicles has the multi-layered thin metal films as the infrared cut-off layer by means of sputtering, thereby improving optical properties such as visible light transmittance and the like.

Further, the low-emissivity film for buildings and vehicles according to the present invention ensures excellent thermal insulation performance.

Furthermore, the low-emissivity film for buildings and vehicles according to the present invention is attached to window glass on an outer wall of a residential or commercial building or to glass of a vehicle so as to cut off infrared light, thereby providing pleasant driving, living, and working environments.

Besides, the low-emissivity film for buildings and vehicles according to the present invention is multi-layered, thereby having excellent impact resistance and shatter prevention performance.

### [Mode for Invention]

Hereinafter, an explanation on an embodiment of the present invention will be given in detail with reference to the attached drawings. Before the present invention is disclosed and described, it is to be understood that the disclosed embodiments are merely exemplary of the invention, which can be embodied in various forms. In the drawings, components not associated with the explanation are omitted for the clarity of the description, and the sizes of the components shown in the drawing may be magnified for the convenience of the description.

Terms used in this application are used to only describe specific exemplary embodiments and are not intended to restrict the present invention. An expression referencing a singular value additionally refers to a corresponding expression of the plural number, unless explicitly limited otherwise by the context. In this application, terms, such as "comprise", "include", or "have", are intended to designate those characteristics, numbers, steps, operations, elements, or parts which are described in the specification, or any combination of them that exist, and it should be understood that they do not preclude the possibility of the existence or possible addition of one or more additional characteristics, numbers, steps, operations, elements, or parts, or combinations thereof.

Terms, such as the first, the second, and the like may be used to describe various elements, but the elements should not be restricted by the terms. The terms are used to only distinguish one element from the other element.

The present invention may be modified in various ways and may have several exemplary embodiments. Specific exemplary embodiments of the present invention are illustrated in the drawings and described in detail in the detailed description. However, this does not limit the invention within specific embodiments and it should be understood that the invention covers all the modifications, equivalents, and replacements within the idea and technical scope of the invention.

Hereinafter, an explanation of a low-emissivity film for buildings and vehicles having excellent visibility and thermal insulation performance according to the present invention will be given in detail.

The present invention relates to a low-emissivity film for buildings and vehicles, more specifically to a low-emissivity film for buildings and vehicles that is capable of having excellent visibility and thermal insulation performance.

The low-emissivity film for buildings and vehicles includes a transparent substrate layer and an infrared cut-off layer formed on top of the transparent substrate layer.

The transparent substrate layer is a member serving as a support body of the infrared cut-off layer and having visible light transmittance of 70% or more. Only if materials used for the transparent substrate layer satisfy the above-mentioned visible light transmittance, they may not be limited specially.

In detail, the transparent substrate layer is made of a transparent polymer resin, especially a transparent ultraviolet curable resin, thereby preventing a user's visible area from interfering therewith.

For example, the transparent substrate layer is made of transparent polymer resins comprising any one or more resins selected from the group consisting of a polyester resin, an acryl resin, a cellulose resin, a polyolefin resin, a polyvinyl chloride resin, a polycarbonate resin, a phenol resin, and a urethane resin.

For example, the transparent polymer resins are made of preferably acryl, polyester, and polycarbonate resins having good balance of thermal resistance and flexibility, more preferably biaxial stretching polyester and polycarbonate resins.

For example, the transparent substrate layer is not limited specially in thickness, but it may have a thickness of 5, 10, 20, or 30 µm or more, while having the maximum thickness of 150 or 200 µm.

As a result, the low-emissivity film has thermal transmittance of 5.0 W/m²K or less.

For example, the low-emissivity film may have thermal transmittance of 4.6 W/m²K or less. For example, the low-emissivity film has thermal transmittance of 4.2 W/m²K or less.

The low-emissivity film has a total solar energy cut-off rate of 60% or more, preferably 75% or more.

The low-emissivity film has a heat cut-off rate of 99% or more.

The infrared cut-off layer serves to reflect and cut off the infrared light having wavelengths between about 380 and 780 nm. The infrared cut-off layer has a low refractive index and high infrared reflectivity.

For example, the infrared cut-off layer is formed on top of the transparent substrate layer by means of sputtering and has a metal layer comprising any one or more metals selected from the group consisting of nickel (Ni), chrome (Cr), and silver (Ag).

The sputtering is a method that is carried out by injecting sputtering gas into a chamber in a vacuum atmosphere to produce plasma, allowing particles in the plasma to collide against a target to be formed as a film, and coating materials separated from the target by means of the collision onto a substrate. Generally, argon as an inert gas is used as the sputtering gas. In a sputtering system, the target is used as a cathode, and the substrate as an anode.

If power is applied, the injected sputtering gas collides against the electrons emitted from the cathode and is ionized (Ar+), and the ions are attracted to the target as the cathode and collide against the target. Under the collision, the energy the ions have had is transferred to the target, and atoms and molecules of the target are emitted to the inside of the chamber, so that the emitted target materials are formed as a thin film on the substrate.

A method for forming the thin film using the sputtering is capable of precisely adjusting a thickness of a coated layer to the range of several tens of nm and easily performing local coating simply using a mask.

The infrared cut-off layer includes the metal layer, especially two or more thin metal films laminated on top of each other.

The infrared cut-off layer includes the two or more thin metal films formed repeatedly on the transparent substrate layer.

For example, the metal layer is composed of two-layer thin silver films, two-layer thin nickel films, or two-layer thin chrome films. Otherwise, the metal layer is composed of three or more-layer thin metal films, preferably five-layer thin metal films.

Further, if necessary, the metal layer is composed of a thin silver film, a thin nickel film, and a thin chrome film laminated on top of one another sequentially or non-sequentially.

More preferably, the metal layer is composed of five-layer thin silver films laminated on top of one another.

Further, the infrared cut-off layer includes a dielectric layer between the respectively metal films.

The dielectric layer has high refractive index and low optical absorbance so as to improve the surface reflection suppression and visible light transmittance of the low-emissivity film according to the present invention.

For example, the dielectric layer comprises any one or more compounds selected from the group consisting of titanium oxide (TiO₂), aluminum oxide (Al₂O₃), zirconium oxide (ZrO₂), tantalum oxide (Ta₂O₅), niobium oxide (Nb₂O₅), lanthanum oxide (La₂O₃), yttrium oxide (Y₂O₃), zinc oxide (ZnO), zinc sulfide (ZnS), and indium oxide (In₂O₃).

For example, the dielectric layer preferably comprises zinc oxide (ZnO) or titanium oxide (TiO₂).

In this case, each thin metal film has preferably a thickness of 5 to 20 nm, more preferably a thickness of 5 to 15 nm, most preferably a thickness of 7 to 10 nm.

For example, the infrared cut-off layer has preferably a thickness of 10 to 100 nm, more preferably a thickness of 30 to 70 nm, most preferably a thickness of 40 to 50 nm.

The infrared cut-off layer is composed of the multi-layered thin metal films so that it has a higher thickness than the existing infrared cut-off layer, thereby improving thermal insulation performance and preventing optical properties such as visible light transmittance from being deteriorated, in spite of having such a high thickness.

The low-emissivity film for buildings and vehicles according to the present invention further includes an overcoat layer formed on top of the infrared cut-off layer, a functional layer formed on top of the overcoat layer, and a protection film formed on top of the functional layer.

The overcoat layer serves to keep the transmittance for visible light and prevent the infrared cut-off layer from being damaged. The overcoat layer is not limited specially in material, and therefore, a general material used for the overcoat layer in the art may be freely used. For example, the overcoat layer includes a single or multiple-functional photocurable organic compound or cured product of a composition having inorganic or organic particles.

The overcoat layer has a thickness of 100 nm or less. If the overcoat layer is greater than the above thickness, the low-emissivity film may have low transmittance, and further, the infrared reflection function of the low-emissivity film may be deteriorated due to the infrared absorption of the overcoat layer.

The functional layer is formed on top of the overcoat layer, and the functional layer is formed of a hydrophobic coating layer, a flame retardant layer, a shatter-proof layer, or a glare prevention layer or a combination thereof.

The protection film is formed on top of the functional layer. The protection film protects the infrared cut-off film from external forces generated when the infrared cut-off film is treated, moved, or attached or from external environments. The protection film peels off from one surface of the infrared cut-off film, without having any damage on the overcoat layer, when the low-emissivity film according to the present invention is attached.

The protection film may be a polymer film known in the art. For example, the protection film is a polyester film such as a polyethylene terephthalate film or a polybutylene terephthalate film or a plastic film such as a polytetrafluoroethylene film, a polyethylene film, a polypropylene film, a polybutene film, a polybutadiene film, a poly(chloride) film, or a polyimide film. The films may be used as a single layer, and otherwise, they may be multi-layered. The protection film may not be limited specially in thickness, but it has a thickness in the range between 10 and 100 µm.

The low-emissivity film for buildings and vehicles according to the present invention further includes an ultraviolet cut-off layer formed on top of the transparent substrate layer.

In detail, the ultraviolet cut-off layer and the infrared cut-off layer are laminated sequentially on top of the transparent substrate layer. As a first example, the ultraviolet cut-off layer is formed on top of the transparent substrate layer, and next, the infrared cut-off layer is formed on top of the ultraviolet cut-off layer. As a second example, the infrared cut-off layer is formed on top of the transparent substrate layer, and next, the ultraviolet cut-off layer is formed on top of the infrared cut-off layer.

The ultraviolet cut-off layer of the low-emissivity film for buildings and vehicles according to the present invention has a thickness of 3 mm or more.

Hereinafter, the present invention will be explained in more detail through embodiments and comparison examples.

However, the embodiments and comparison examples are just exemplary, and therefore, the present invention may not be limited to them.

### Embodiment 1 (Two-layer thin films)

A transparent glass substrate (Corning 1747) as a transparent substrate was put in a dry depositor and fixed thereto, and an interior of the depositor was made to a vacuum state of about 1 × 10⁻⁷ Torr. If a pressure condition of the depositor was satisfied, argon (10 sccm) was injected into the depositor so that the depositor was kept at 1 × 10⁻³ Torr, and next, power of 50 W with a radio frequency (RF) of 13.56 MHz was applied to a sputtering gun located inside the depositor, thereby producing plasma. After that, a thin silver film having a mean thickness of 20 nm, a titanium oxide layer having a mean thickness of 10 nm, and a thin silver film having a mean thickness of 20 nm were laminated sequentially on top of the transparent glass substrate by means of RF/DC sputtering, thereby making a low-emissivity film.

### Embodiment 2 (Three-layer thin films)

A low-emissivity film according to the second embodiment of the present invention was made in the same manner as according to the first embodiment of the present invention, except that a thin silver film having a mean thickness of 10 nm, a titanium oxide layer having a mean thickness of 5 nm, a thin silver film having a mean thickness of 10 nm, a titanium oxide layer having a mean thickness of 5 nm, and a thin silver film having a mean thickness of 10 nm were deposited sequentially on top of the transparent glass substrate by means of RF/DC sputtering.

### Embodiment 3 (Four-layer thin films)

A low-emissivity film according to the third embodiment of the present invention was made in the same manner as according to the first embodiment of the present invention, except that a thin silver film having a mean thickness of 10 nm, a titanium oxide layer having a mean thickness of 2 nm, a thin silver film having a mean thickness of 10 nm, a titanium oxide layer having a mean thickness of 2 nm, a thin silver film having a mean thickness of 10 nm, a titanium oxide layer having a mean thickness of 2 nm, and a thin silver film having a mean thickness of 10 nm were deposited sequentially on top of the transparent glass substrate by means of RF/DC sputtering.

### Embodiment 4 (Five-layer thin films)

A low-emissivity film according to the fourth embodiment of the present invention was made in the same manner as according to the first embodiment of the present invention, except that a thin silver film having a mean thickness of 8 nm, a titanium oxide layer having a mean thickness of 2 nm, a thin silver film having a mean thickness of 8 nm, a titanium oxide layer having a mean thickness of 2 nm, a thin silver film having a mean thickness of 8 nm, a titanium oxide layer having a mean thickness of 2 nm, a thin silver film having a mean thickness of 8 nm, a titanium oxide layer having a mean thickness of 2 nm, and a thin silver film having a mean thickness of 8 nm were deposited sequentially on top of the transparent glass substrate by means of RF/DC sputtering.

### Comparison example 1

An infrared cut-off film according to the comparison example 1 was made in the same manner as according to the first embodiment of the present invention, except that a thin silver film having a mean thickness of 70 nm was deposited on top of the transparent glass substrate by means of RF/DC sputtering.

### Comparison example 2

An infrared cut-off film according to the comparison example 2 was made in the same manner as according to the first embodiment of the present invention, except that a thin silver film having a mean thickness of 100 nm was deposited on top of the transparent glass substrate by means of RF/DC sputtering.

Optical performance tests for the films of the above-mentioned embodiments and the comparison examples were carried out according to KS L 2016:2014, 6.3, and the test results are listed in the following Table 1. A test environment was kept to temperature of 21 to 25°C and humidity of 60 to 65% RH. The measurements were carried out using T-IR spectrophotometer (Nicolet, 6700, U.S.A.) and UV-VIS-NIR spectrophotometer (Perkin-Elmer, Lambda 950&1050, U.S.A.).

**[Table 1]**

| | Embodiment 1 | Embodiment 2 | Embodiment 3 | Embodiment 4 | Comparison 1 | Comparison 2 |
|---|---|---|---|---|---|---|
| Visible light transmittance (TL:%) | 52.6 | 53.4 | 54.8 | 56.7 | 46.8 | 47.0 |
| Solar energy transmittance (TE:%) | 39.2 | 38.5 | 37.4 | 34.5 | 43.2 | 39.5 |
| Solar energy absorptance (AE:%) | 19.5 | 19.9 | 18.4 | 17.7 | 21.5 | 19.2 |
| Shading coefficient (SC) | 0.30 | 0.42 | 0.45 | 0.47 | 0.62 | 0.53 |
| Thermal Transmittance (U-value: W/m²K) | 4.5 | 4.6 | 4.5 | 4.2 | 5.1 | 6.2 |
| Solar heat gain coefficient (SHGC) | 0.26 | 0.42 | 0.40 | 0.40 | 0.47 | 0.51 |

It can be appreciated that the low-emissivity films according to the first to fifth embodiments of the present invention have thermal transmittance of 5.0 W/m²K or less, thereby having excellent thermal insulation performance. General sheet glass has thermal transmittance of about 6.0 W/m²K, and a general insulation film on the market has thermal transmittance between 5.7 and 6.0 W/m²K. Further, it can be appreciated that the low-emissivity films according to the embodiments of the present invention have visible light transmittance of 52% or more, whereas in the comparison examples, visible light transmittance becomes reduced to about 47% because the thicknesses of the films increase.

In this case, it is checked that the low-emissivity film according to the fourth embodiment of the present invention has thermal transmittance of 4.2 W/m²K, which means that it has very excellent thermal insulation performance. However, it is appreciated that the thermal transmittance of the comparison examples having a relatively thick single layer is lower than that of the low-emissivity films according to the first to fifth embodiments of the present invention, and further, it is checked that the visible light transmittance as optical properties of the comparison examples is lower than that of the low-emissivity films according to the first to fifth embodiments of the present invention.

Besides, it can be appreciated that the low-emissivity films according to the first to fifth embodiments of the present invention have solar energy transmittance less than 40% and the low-emissivity film according to the fifth embodiment of the present invention has solar energy transmittance of 34.5%. That is, it can be appreciated that the low-emissivity films according to the first to fifth embodiments of the present invention have a total solar energy cut-off rate of 60% or more.

That is, it can be checked that the low-emissivity films according to the first to fifth embodiments of the present invention have the infrared cut-off layer composed of the multilayer thin metal films, thereby improving the optical properties such as the visible light transmittance or the like and ensuring excellent thermal insulation performance.

It is to be understood that the disclosed embodiments are merely exemplary of the invention, which can be embodied in various forms. Those skilled in the art will envision many other possible variations within the scope of the present invention. For example, the parts expressed in a singular form may be dispersedly provided, and in the same manner as above, the parts dispersed may be combined with each other.

While the present invention has been described with reference to the particular illustrative embodiments, it is not to be restricted by the embodiments but only by the appended claims. It is to be appreciated that those skilled in the art can change or modify the embodiments without departing from the scope and spirit of the present invention.

## Claims

1. A low-emissivity film for buildings and vehicles, comprising:
a transparent substrate layer; and
an infrared cut-off layer formed on top of the transparent substrate layer by means of sputtering and having a metal layer comprising any one or more metals selected from the group consisting of nickel, chrome, and silver,
wherein the low-emissivity film has thermal transmittance of 5.0 W/m²K or less.

2. The low-emissivity film according to claim 1, wherein the infrared cut-off layer is composed of two or more thin films formed by repeating the metal layer, and each thin film has a thickness between 30 and 100 nm.

3. The low-emissivity film according to claim 1, further comprising an ultraviolet cut-off layer formed on the transparent substrate layer.

4. The low-emissivity film according to claim 1, having a thickness of 3 mil or more.

5. The low-emissivity film according to claim 1, having thermal transmittance of 4.6 W/m²K or less.

6. The low-emissivity film according to claim 1, having thermal transmittance of 4.2 W/m²K or less.

7. The low-emissivity film according to claim 1, having a total solar energy cut-off rate of 60% or more.

8. The low-emissivity film according to claim 1, having total solar energy cut-off rate of 75% or more.

9. The low-emissivity film according to claim 1, having a heat cut-off rate of 99% or more.
